# FASCICULE DE BREVET EUROPEEN

(11) **EP 2 769 405 B1**
(45) Date de publication et mention de la délivrance du brevet: **24.05.2023**
(21) Numéro de dépôt: 12787779.3
(22) Date de dépôt: 19.10.2012
(51) Int. Cl.: H01L 21/208, H01L 21/368, B82Y 10/00, B82Y 40/00, C01B 19/00

(54) **PROCEDE DE CROISSANCE EN EPAISSEUR DE NANOFEUILLETS COLLOÏDAUX ET MATERIAUX COMPOSES DESDITS NANOFEUILLETS**
VERFAHREN ZUR VERSTÄRKUNG DER DICKE VON KOLLOIDALEN NANOSHEETS UND MATERIALIEN AUS DIESEN NANOSHEETS
PROCESS FOR THE THICKNESS GROWTH OF COLLOIDAL NANOSHEETS AND MATERIALS COMPOSED OF SAID NANOSHEETS

(30) Priorité: 19.10.2011 FR 1103184
(43) Date de publication de la demande: 27.08.2014
(73) Titulaire: Nexdot, 93230 Romainville (FR)
(72) Inventeur: MAHLER, Benoît, 75013 Paris (FR)
(74) Mandataire: Icosa
(86) Numéro de dépôt international: PCT/FR2012/052393
(87) Numéro de publication internationale: WO 2013/057446

(56) Documents cités:
- US-A1- 2004 110 002
- US-A1- 2009 315 016
- FENGSHI CAI ET AL: "TiO coated SnO nanosheet films for dye-sensitized solar cells", THIN SOLID FILMS, ELSEVIER-SEQUOIA S.A. LAUSANNE, CH, vol. 519, no. 16, 3 mars 2011 (2011-03-03) , pages 5645-5648, XP028089139, ISSN: 0040-6090, DOI: 10.1016/J.TSF.2011.03.013 [extrait le 2011-03-16]
- LI Z ET AL: "Size/shape-controlled synthesis of colloidal CdSe quantum disks: Ligand and temperature effects", 4 mai 2011 (2011-05-04), JOURNAL OF THE AMERICAN CHEMICAL SOCIETY 20110504 AMERICAN CHEMICAL SOCIETY USA, VOL. 133, NR. 17, PAGE(S) 6578 - 6586, XP002678847, *Sections "Introduction"; "Results"; "Discussion"; "Experimental Section"; figures 1-9*
- YI ZHANG ET AL: "Aqueous Layer-by-Layer Epitaxy of Type-II CdTe/CdSe Quantum Dots with Near-Infrared Fluorescence for Bioimaging Applications", SMALL, vol. 5, no. 2, 19 janvier 2009 (2009-01-19), pages 185-189, XP055050695, ISSN: 1613-6810, DOI: 10.1002/smll.200800473
- LI J ET AL: "Preparation, conversion, and comparison of the photocatalytic property of Cd(OH)2, CdO, CdS and CdSe", JOURNAL OF PHYSICS AND CHEMISTRY OF SOLIDS, PERGAMON PRESS, LONDON, GB, vol. 70, no. 9, 1 septembre 2009 (2009-09-01), pages 1285-1289, XP026521656, ISSN: 0022-3697, DOI: 10.1016/J.JPCS.2009.07.014 [extrait le 2009-07-17]
- YU DONG ET AL: "Electronic transport of n-type CdSe quantum dot films: Effect of film treatment", JOURNAL OF APPLIED PHYSICS, AMERICAN INSTITUTE OF PHYSICS. NEW YORK, US, vol. 99, no. 10, 31 mai 2006 (2006-05-31), pages 104315-104315, XP012083284, ISSN: 0021-8979
- ITHURRIA S. ET AL: "Quasi 2D Colloidal CdSe Platelets with Thicknesses Controlled at the Atomic Level", JOURNAL OF THE AMERICAN CHEMICAL SOCIETY, AMERICAN CHEMICAL SOCIETY, vol. 130, no. 49, 14 November 2008 (2008-11-14), pages 16504-16505, XP002573191, ISSN: 0002-7863, DOI: 10.1021/JA807724E [retrieved on 2008-11-14]
- MANNA L ET AL: "Epitaxial Growth and Photochemical Annealing of Graded CdS/ZnS Shells on Colloidal CdSe Nanorods", JOURNAL OF THE AMERICAN CHEMICAL SOCIETY, AMERICAN CHEMICAL SOCIETY, US, vol. 124, no. 24, 24 May 2002 (2002-05-24) , pages 7136-7145, XP002612686, ISSN: 0002-7863, DOI: 10.1021/JA025946I [retrieved on 2002-05-24]
- Sungjee Kim ET AL: "Type-II Quantum Dots: CdTe/CdSe(Core/Shell) and CdSe/ZnTe(Core/Shell) Heterostructures", Journal of the American Chemical Society, vol. 125, no. 38, 29 August 2003 (2003-08-29), pages 11466-11467, XP055276844, ISSN: 0002-7863, DOI: 10.1021/ja0361749
- MICHEL NASILOWSKI ET AL: "Two-Dimensional Colloidal Nanocrystals", CHEMICAL REVIEWS, vol. 116, no. 18, 19 July 2016 (2016-07-19), pages 10934-10982, XP055639610, US ISSN: 0009-2665, DOI: 10.1021/acs.chemrev.6b00164

## Description

### DOMAINE DE L'INVENTION

La présente invention concerne un procédé de croissance en épaisseur d'au moins une face d'un nanofeuillet colloïdal inorganique. L'invention concerne en outre les matériaux homo-structurés ou hétéro-structurés résultant d'un tel procédé ainsi que les applications desdits matériaux. On désigne par nanofeuillet une structure présentant au moins une dimension, l'épaisseur, de taille nanométrique et des dimensions latérales grandes devant l'épaisseur, typiquement plus de 5 fois l'épaisseur. On désigne par homo-structuré un matériau de composition homogène en épaisseur et par hétéro-structuré un matériau de composition hétérogène en épaisseur.

La présente invention concerne plus particulièrement un procédé permettant le dépôt d'au moins une monocouche d'atomes sur au moins un nanofeuillet colloïdal inorganique, cette monocouche étant constituée d'atomes différents de ceux contenus dans le dit nanofeuillet.

### ÉTAT DE LA TECHNIQUE

La fabrication de structures présentant au moins une dimension de taille nanométrique induit l'apparition de propriétés physiques nouvelles. Ces structures ont des caractéristiques qui peuvent notablement différer de celles du matériau massif de composition chimique identique.

Ces faibles dimensions (à l'échelle nanométrique) conduisent en effet à une modification des propriétés électroniques¹, optiques², magnétiques³ ou plasmoniques⁴.

Ces nouveaux matériaux suscitent ainsi un intérêt qui va croissant dans des domaines aussi variés que l'optique, l'imagerie, l'électronique ou la catalyse.

Les différentes nanostructures existantes peuvent être classées en fonction du nombre de dimensions de taille nanométrique qu'elles présentent. Ainsi, un nanocristal isotrope est une structure nanométrique dans les trois dimensions, tandis qu'un nano-fil est une structure nanométrique dans deux dimensions. Manna et al. décrit des nanobâtonnets CdSe ayant une coque CdS/ZnS (Manna et al., Journal of the American Chemical Society, 2002, Vol. 124, p. 7136-7145). Zhang et al. décrit des quantum dots de structure coeur/écorce CdTe/CdSe ("Aqueous layer-by-layer Epitaxy of Type-II CdTe/CdSe Quantum dots with near-infrared fluorescence for bioimaging applications", Small, January 2009, vol.5, no.2, pages 185-189).

La présente invention concerne des structures nanométriques dans une seule dimension, à savoir des nanofeuillets, que nous désignerons par la suite indifféremment feuillets ou nanofeuillets. Elle concerne plus particulièrement les nanofeuillets colloïdaux, c'est à dire les nanofeuillets qui peuvent être dispersés en solution. La présente invention a pour objet la croissance ultérieure de nanofeuillets, i.e. la croissance en épaisseur d'un nanofeuillet initial.

La synthèse de nanofeuillets inorganiques colloïdaux a connu un fort développement depuis le début des années 2000. Il est possible de distinguer plusieurs types de synthèses, chacune associée à un ensemble de matériaux différents. Les principales approches existantes, qui seront détaillées dans la suite, sont l'exfoliation directe d'un matériau lamellaire, la synthèse chimique de mono-feuillets de matériaux lamellaires, la croissance de nanofeuillets par empoisonnement (ce qui bloque la croissance) de certaines faces cristallines par des ligands, et enfin le passage par un composé intermédiaire de structure lamellaire subissant une transformation topotactique.

L'exfoliation directe est utilisée couramment afin de produire des nanofeuillets de graphène, d'hydroxydes ou d'oxydes⁵ (TiO₂ par exemple). Le mode de préparation consiste généralement à diminuer l'énergie d'interaction entre les nanofeuillets afin de les séparer mécaniquement par la suite. Dans le cas de composés ioniques on provoque un gonflement de l'espace inter-feuillets (contenant généralement des ions positifs) en réalisant un échange des cations par un ion fortement encombré tel que l'hydroxyde de tétrabutylammonium⁶. Ce gonflement affaiblit les interactions entre les nanofeuillets qui peuvent alors être séparés mécaniquement par sonication par exemple. Dans le cas du graphite, la diminution de l'énergie d'interaction inter-feuillets peut être réalisée par l'utilisation d'un solvant adéquat tel que le N-methylpyrrolidone⁷. Ce type de procédé conduit toujours à l'obtention de mono-feuillets de quelques Angström d'épaisseur. Il n'y a pas de croissance ultérieure possible. La dimension des nanofeuillets dépend de la dimension de l'objet massif exfolié. Un contrôle de l'épaisseur du nanofeuillet n'est pas envisageable, celle-ci étant fixée par la structure lamellaire du composé de départ et donc par sa nature chimique.

Il existe également de nombreuses synthèses directes de mono-feuillets. Il est par exemple possible de faire croître du graphène directement sur un substrat de cuivre. Il est également possible par des méthodes de synthèse en solution de préparer directement des mono-feuillets de GeS ou GeSe⁸ ou encore des feuillets multiples de Bi₂Te₃⁹. Ces synthèses ne permettent toutefois pas de contrôle de l'épaisseur des nanofeuillets ni de croissance ultérieure en épaisseur de ceux-ci.

Une approche beaucoup plus versatile, permettant de fabriquer des nanofeuillets dans une grande variété de matériaux différents consiste en l'empoisonnement de certaines facettes cristallines par les ligands de surface adéquats. L'adsorption préférentielle de molécules sur certaines faces cristallines du matériau considéré bloque la croissance dans les directions perpendiculaires à ces facettes et induit alors une croissance cristalline fortement anisotrope^{10,11}. Il est à noter que la molécule empoisonnante peut être de nature très variée : tensio-actifs¹², polymères¹³, thiols¹⁴, amines^{15,16,17}, ions inorganiques¹⁸. Les matériaux ainsi synthétisés peuvent être par exemple :
- des nanofeuillets de métaux (PVP^{13, 19, 20}, CTAB²¹, ions^{18, 22})
- des nanofeuillets d'oxydes de terres rares^{17, 23} (acide oléique et/ou oleylamine)
- des nanofeuillets de sulfures (Cu₂S en présence de thiols¹⁴)

Ce mode de fabrication, bien qu'étant extrêmement général, possède tout de même certaines limitations et notamment ne permet pas la croissance ultérieure en épaisseur d'un nanofeuillet initial.

Une autre approche consiste à synthétiser des nanofeuillets en tirant parti de la formation d'un intermédiaire lui-même lamellaire. Cette approche peut être mise à profit afin de réaliser des nanofeuillets de métaux (Cobalt, Nickel ou Cuivre²⁴) ou d'oxydes (oxyde de magnésium MgO²⁵) en passant par un hydroxyde lamellaire. De même, de nombreux chalcogènes lamellaires sont obtenus par formation préalable d'un complexe Métal-(amine primaire) de structure lamellaire qui réagit ultérieurement avec un précurseur de soufre ou de sélénium. Il est ainsi possible de former des nanofeuillets de CdSe²⁶, de CdMnSe²⁷, de ZnS²⁸⁻³¹, ou encore d'In2S₃³². Il est à noter qu'un complexe plomb-thio-urée lamellaire permet également la formation de nanofeuillets de PbS³³. Cette autre approche a permis pour la première fois d'obtenir des nanofeuillets de chalcogènes dont l'épaisseur est définie à la monocouche atomique près. Ainsi, depuis 2001 sont apparus des protocoles de synthèse permettant de fabriquer des matériaux semi-conducteurs lamellaires hybrides organique/inorganique³⁴. Le nanofeuillet élémentaire de ces matériaux est constitué d'une monocouche ou d'une bicouche semi-conductrice (ZnS³⁵ par exemple), en structure wurtzite, d'axe de zone [1, 1, 0] dont la surface est stabilisée par une amine primaire. Le protocole de synthèse, très général, permet de l'appliquer a des matériaux variés : CdSe, CdS, ZnS, ZnSe, ZnTe ... Cette approche a été partiellement modifiée en 2006 afin d'obtenir des nanofeuillets individuels de CdSe simplement en modifiant la longueur de la chaine alkyle de l'amine primaire utilisée^{26, 36}. Le contrôle de l'épaisseur de ce type de nanofeuillets reste limité et leur épaisseur ne dépasse pas les 5 monocouches. En conséquence, les propriétés optiques de ces nanofeuillets sont très limitées : fluorescence circonscrite dans la région bleue et ultraviolette du spectre visible, largeur à mi-hauteur du pic de fluorescence supérieure à 12nm. De plus, une croissance en épaisseur ultérieure reste impossible sur ces nanofeuillets.

Plus récemment, en 2008, une nouvelle approche qui permet d'améliorer considérablement le contrôle de l'épaisseur des nanofeuillets semi-conducteurs synthétisés a été développée³⁷⁻³⁹. Dans ce cas, les nanofeuillets sont composés par un nanofeuillet semi-conducteur (CdSe, CdS ou CdTe) de structure zinc-blende, d'axe de zone [0, 0, 1] présentant une couche cationique stabilisé par des carboxylates de chaque côté du nanofeuillet. Ce type de synthèse permet de contrôler très précisément l'épaisseur du nanofeuillet semi-conducteur, qui peut être comprise entre 4 et 11 monocouches suivant le protocole de synthèse utilisé. De tels nanofeuillets semi-conducteurs colloïdaux présentent des propriétés électroniques et optiques novatrices, du fait en particulier de leur épaisseur parfaitement contrôlée. Ainsi, la fluorescence de ces objets est caractérisée par un spectre d'émission très étroit (moins de 10 nm de largeur à mi-hauteur) et les longueurs d'ondes accessibles en fluorescence couvrent l'ensemble du spectre visible. Cependant, cette nouvelle approche ne permet pas la croissance ultérieure en épaisseur d'un nanofeuillet initial.

Ainsi, les méthodes actuelles permettent de synthétiser des nanofeuillets dont l'épaisseur n'est pas toujours bien contrôlée.

Il existe également à ce jour deux types de procédés de croissance en solution de films de semi-conducteurs sur un matériau initial : les procédés de croissance sur des nanocristaux colloïdaux et les procédés de croissance sur substrat.

Dans le cas des procédés de croissance sur des nanocristaux colloïdaux tels que les « quantum dots » (nanocristaux de semi-conducteurs), les procédés de croissance connus font intervenir un excès de ligands et des températures élevées (plus de 200°C)⁴⁰⁻⁴². Le document US 2004/110002 décrit ainsi le dépôt d'une coque sur des nanoparticules sphériques, à haute température, à savoir 100-200°C, dans un mélange trioctylphosphine/oxyde de trioctylphosphine qui joue le rôle de solvant et de ligand fortement coordinant. Dans de telles conditions, il est très difficile d'assurer la stabilité des nanofeuillets. En effet, du fait de leur structure 2D, les nanofeuillets se dégradent et se dissolvent lorsque ces procédés de croissance sont utilisés.

Ithurria S. et al, "Quasi 2D Colloïdal CdSe Platelets with Thicknesses Controlled at the Atomic Level", Journal of the American Chemical Society , vol. 130, no. 49, 14.11.2008, pages 16504-16505, décrit un procédé de croissance en solution de nanofeuillets CdSe.

Dans le cas des procédés de croissance sur substrat, les procédés connus sont mis en oeuvre en solution aqueuse et à température ambiante. On distingue la CBD : « Chemical Bath Déposition » croissance en bain chimique⁴³ et la SILAR : « Successive Ion Layer Adsorption and Reaction » croissance par adsorption et réaction successive de couches ioniques⁴⁴. Ces procédés, pour pouvoir être appliqués à des nanofeuillets, nécessiteraient un ensemble de conditions difficiles à réunir, par exemple une modification préalable des ligands de surface des nanofeuillets, un contrôle précis du pH ou encore une absence de complexants (complexants qui pourraient entraîner une dissolution des nanofeuillets). La stabilité en solution des nanofeuillets inorganiques semi-conducteurs résulte de la présence de ligands organiques et de leur interaction avec le matériau cristallin. La modification de ces interactions par chauffage ou suppression des ligands provoque l'agrégation ou la destruction des nanofeuillets par dissolution ou changement de forme vers une structure thermodynamique plus stable.

Aussi la croissance dans l'épaisseur de ces objets n'est pas réalisable avec les techniques connues décrites ci-dessus.

Aucune des méthodes décrites ci-dessus ne permet d'obtenir une particule inorganique comprenant un nanofeuillet initial. Or, ce matériau final présente de nombreux avantages : il est notamment possible de recouvrir tout ou partie du nanofeuillet initial par une ou plusieurs couches d'un matériau différent du matériau constituant le nanofeuillet initial, ce qui permet d'obtenir un matériau final présentant des propriétés très intéressantes, en terme de stabilité ou de propriétés optiques.

L'objet de la présente invention est donc de fournir un nouveau procédé permettant la croissance ultérieure en épaisseur d'un nanofeuillet initial par le biais de dépôt d'au moins une couche de matériau inorganique sur ledit nanofeuillet initial.

La présente invention permet donc d'obtenir des particules inorganiques comprenant un nanofeuillet inorganique recouvert partiellement ou totalement par au moins une couche de matériau inorganique.

### RÉSUMÉ

Un objet de l'invention est une particule colloïdale inorganique selon les revendications 1 à 2.

Un autre objet de l'invention est un procédé de croissance en épaisseur d'au moins une face d'au moins un nanofeuillet initial selon les revendications 3 à 7.

Un autre objet de l'invention est un système luminescent, électroluminescent ou un étage d'amplification d'un laser selon la revendication 8.

Un autre objet de l'invention est une cellule photovoltaïque selon la revendication 9.

Un autre objet de l'invention est un transistor selon la revendication 10.

### DESCRIPTION DÉTAILLÉE

Au sens de la présente invention, les termes feuillets et nanofeuillets sont équivalents. Un nanofeuillet présente une structure cristalline quasi-2D dont au moins une des dimensions, de préférence l'épaisseur, est inférieure à 1 µm. Les dimensions latérales, i.e. la largeur et la longueur, du nanofeuillet sont grandes par rapport à l'épaisseur, i.e. au moins 1,5 fois plus grandes. Le nanofeuillet est anisotrope.

L'accroissement de l'épaisseur du nanofeuillet initial permet d'étendre de manière significative les caractéristiques spectrales de ce feuillet telles que les spectres d'émission ou d'absorption. Il apparaît donc souhaitable de développer une méthode de croissance en épaisseur pour atteindre des épaisseurs plus grandes. De plus, il serait souhaitable pour de nombreuses applications de pouvoir déposer sur le nanofeuillet initial un matériau différent de celui le constituant.

Ainsi, les particules finales accrues en épaisseur selon l'invention présentent des propriétés nouvelles ou améliorées en comparaison des nanofeuillets initiaux, telles que un rendement quantique élevé, une stabilité accrue, une meilleure stabilité de surface, une faible largeur à mi-hauteur de fluorescence (moins de 30nm, de préférence moins de 25nm), un temps de vie de fluorescence rapide (moins de 40 ns, de préférence moins de 10ns), une section efficace d'absorption importante (environ ou plus de 10⁻¹³ cm² à 400nm), un réglage possible de la longueur d'onde d'émission, une robustesse dans le temps des propriétés optiques, une grande surface spécifique.

La présente invention a donc pour objet une particule selon la revendication 1.

Au sens de la présente invention, le terme « couche » correspond à un film ou une couche continu ou partiel ayant au moins 1 atome d'épaisseur. Le terme « monocouche » correspond à un film ou une couche continu ou partiel ayant 1 atome d'épaisseur. Les atomes composant la couche ou la monocouche peuvent être identiques ou différents.

Dans un mode de réalisation où plusieurs couches recouvrent tout ou partie du nanofeuillet initial, ces couches peuvent être composées du même matériau ou composées de différents matériaux.

Dans un mode de réalisation où plusieurs couches recouvrent tout ou partie du nanofeuillet initial, ces couches sont composées de façon à former un gradient de matériaux.

Dans un mode de réalisation, le nanofeuillet initial est un nanofeuillet colloïdal inorganique.

Dans un mode de réalisation, le nanofeuillet initial est cristallin.

Dans un mode de réalisation, la particule ou l'objet final est un nanofeuillet.

Dans un mode de réalisation, la particule ou l'objet final est inorganique.

Dans un mode de réalisation, la particule ou l'objet final est colloïdal.

Dans un mode de réalisation, la particule ou l'objet final est cristallin.

Dans un mode de réalisation, le nanofeuillet initial compris dans la particule ou l'objet final a conservé sa structure quasi-2D.

Dans un mode de réalisation, le matériau recouvrant le nanofeuillet initial est inorganique.

Dans un mode de réalisation, au moins une partie de la particule ou de l'objet final a une épaisseur supérieure à l'épaisseur du nanofeuillet initial.

Dans un mode de réalisation, la particule ou l'objet final comprend le nanofeuillet initial recouvert en totalité par au moins une couche de matériau.

Dans un mode de réalisation, la particule ou l'objet final comprend le nanofeuillet initial recouvert en totalité par une première couche de matériau, ladite première couche étant recouverte partiellement ou totalement par au moins une seconde couche de matériau.

Dans un mode de réalisation, le nanofeuillet initial présente une épaisseur de 0,3 nm à moins de 500 nm, de 5 nm à moins de 250 nm, de 0,3 nm à moins de 100 nm, de 0,3 nm à moins de 50 nm, de 0,3 nm à moins de 25 nm, de 0,3 nm à moins de 20 nm, de 0,3 nm à moins de 15 nm, de 0,3 nm à moins de 10 nm, de 0,3 nm à moins de 5 nm.

Dans un mode de réalisation, au moins une des dimensions latérales (longueur ou largeur) du nanofeuillet initial représente au moins 3,5 fois l'épaisseur du nanofeuillet initial, au moins 4 fois l'épaisseur du nanofeuillet initial, au moins 4,5 fois l'épaisseur du nanofeuillet initial, au moins 5 fois l'épaisseur du nanofeuillet initial.

Dans un mode de réalisation, les dimensions latérales du nanofeuillet initial sont de au moins 0.45 nm à au moins 2500 nm.

Dans un mode de réalisation, au moins une des dimensions latérales du nanofeuillet initial est de 2 nm à 1m, de 2 nm à 100 mm, de 2 nm à 10 mm, de 2 nm à 1 mm, de 2 nm à 100 µm, de 2 nm à 10 µm, de 2 nm à 1 µm, de 2 nm à 100 nm, de 2 nm à 10 nm.

Dans des exemples qui constituent des modes de réalisation selon l'invention uniquement dans les limites de la revendication 1, le matériau composant le nanofeuillet initial comprend un matériau ME, où
M est Cd,
E est S, Se, ou un mélange de ceux-ci, ou Te.

Dans un mode de réalisation, le matériau semi-conducteur composant le nanofeuillet initial comprend un composant du groupe II-VI.

Dans un mode de réalisation, le matériau composant le nanofeuillet initial comprend au moins un semi-conducteur choisi parmi CdS, CdSe, ou un mélange de ceux-ci, ou CdTe.

Dans un mode de réalisation, le matériau composant le nanofeuillet initial comprend au moins un semi-conducteur choisi préférentiellement parmi CdS, CdSe, CdTe.

Dans un mode de réalisation, la particule ou l'objet final présente une épaisseur de 0,5 nm à 10 mm, de 0,5 nm à 1 mm, de 0,5 nm à 100 µm, de 0,5 nm à 10 µm, de 0.5 nm à 1 µm, de 0.5 nm à 500 nm, de 0,5 nm à 250 nm, de 0,5 nm à 100 nm, de 0,5 nm à 50 nm, de 0,5 nm à 25 nm, de 0,5 nm à 20 nm, de 0,5 nm à 15 nm, de 0,5 nm à 10 nm, de 0,5 nm à 5 nm.

Dans un mode de réalisation, au moins une des dimensions latérales (longueur ou largeur) de la particule ou de l'objet final représente au moins 1,5 fois l'épaisseur de la particule ou de l'objet final, au moins 2 fois l'épaisseur de la particule ou de l'objet final, au moins 2,5 fois l'épaisseur de la particule ou de l'objet final, au moins 3 fois l'épaisseur de la particule ou de l'objet final, au moins 3,5 fois l'épaisseur de la particule ou de l'objet final, au moins 4 fois l'épaisseur de la particule ou de l'objet final, au moins 4,5 fois l'épaisseur de la particule ou de l'objet final, au moins 5 fois l'épaisseur de la particule ou de l'objet final.

Dans un mode de réalisation, les dimensions latérales de la particule ou de l'objet final sont de au moins 0.75 nm à au moins 50 mm.

Dans un mode de réalisation, au moins une des dimensions latérales de la particule ou de l'objet final est de 2 nm à 1m, de 2 nm à 100 mm, de 2 nm à 10 mm, de 2 nm à 1 mm, de 2 nm à 100 µm, de 2 nm à 10 µm, de 2 nm à 1 µm, de 2 nm à 100 nm, de 2 nm à 10 nm.

Dans un mode de réalisation, la particule ou l'objet final est hétéro-structuré, i.e. que le nanofeuillet initial et la au moins une couche sont composés d'au moins deux matériaux différents.

Dans un mode de réalisation, la particule ou l'objet final peut comprendre le nanofeuillet initial et au moins une couche recouvrant tout ou partie du nanofeuillet initial, ladite couche étant composée d'un matériau différent de celui du nanofeuillet initial.

Dans un mode de réalisation, la particule ou l'objet final peut comprendre le nanofeuillet initial et 1, 2, 3, 4, 5 ou plus couches recouvrant tout ou partie du nanofeuillet initial, lesdites couches étant de composition différente de celle du nanofeuillet initial ou étant de composition différente entre elles.

Dans un mode de réalisation, la particule ou l'objet final peut comprendre le nanofeuillet initial et au moins 2, 3, 4, 5 ou plus couches, dans lequel la première couche déposée recouvre tout ou partie du nanofeuillet initial et la au moins deuxième couche déposée recouvre tout ou partie de la couche précédemment déposée, lesdites couches étant de composition différente de celle du nanofeuillet initial et pouvant être de composition différente entre elles.

Ainsi dans un mode de réalisation, la particule ou l'objet final comprend le nanofeuillet initial recouvert totalement par au moins une couche continue puis recouvert totalement ou partiellement par au moins une autre couche, lesdites couches étant de composition différente de celle du nanofeuillet initial et pouvant être de composition différente entre elles.

Dans un mode de réalisation, la particule ou l'objet final présente une structure coeur/coque, i.e. un nanofeuillet initial d'une composition donnée recouvert sur toute sa surface d'au moins une couche de composition différente de celle du nanofeuillet initial.

Ainsi, le matériau obtenu est composé d'un empilement de films dont au moins un est de composition chimique différente du nanofeuillet initial, la surface de chaque film couvrant totalement la surface du film sur lequel il est déposé.

Dans un mode de réalisation, la particule ou l'objet final présente une structure démouillée, i.e. un nanofeuillet initial d'une composition donnée recouvert en partie d'au moins une couche de composition différente de celle du nanofeuillet initial.

Ainsi, le matériau obtenu est composé d'un empilement de films dont au moins un est de composition chimique différente du nanofeuillet initial, la surface de chaque film couvrant partiellement la surface du film sur lequel il est déposé.

Dans des exemples qui constituent des modes de réalisation selon l'invention uniquement dans les limites de la revendication 1, le matériau composant la au moins une couche comprend un matériau ME où
M est Zn, Cd, ou un mélange de ceux-ci,
E est O, S, Se, Te, ou un mélange de ceux-ci.

Dans un mode de réalisation, le matériau composant la au moins une couche comprend un composant du groupe II-VI.

Dans des exemples qui constituent des modes de réalisation selon l'invention uniquement dans les limites de la revendication 1, le matériau composant la au moins une couche comprend au moins un semi-conducteur choisi parmi CdS, CdSe, CdTe, ZnS, ZnSe, ZnO, ou un mélange de ceux-ci.

Dans des exemples,qui constituent des modes de réalisation selon l'invention uniquement dans les limites de la revendication 1, le matériau composant la au moins une couche comprend au moins un semi-conducteur choisi préférentiellement parmi CdS, CdSe, CdTe, ZnS, ZnSe.

Dans un mode de réalisation, la particule ou l'objet final n'est pas un nanofeuillet SnO₂ recouvert par du TiO₂.

Dans un mode de réalisation, la particule ou l'objet final n'est pas un nanofeuillet TiO₂ recouvert par de l'Argent.

Dans un mode de réalisation, la particule ou l'objet final n'est pas un nanofeuillet homo-structuré composé de SnSe.

La présente invention a pour objet un procédé de croissance en épaisseur d'au moins une face d'au moins un nanofeuillet initial selon la revendication 3.

La présente invention a donc également pour objet une particule ou un objet final obtenu ou susceptible d'être obtenu par le procédé selon la revendication 3.

Dans un mode de réalisation, le nanofeuillet initial est un nanofeuillet inorganique.

Dans un mode de réalisation, le nanofeuillet initial est un nanofeuillet colloïdal.

Dans un mode de réalisation, le nanofeuillet initial est un semi-conducteur.

Dans un mode de réalisation, le matériau constituant le nanofeuillet initial est tel que décrit ci-dessus.

Dans des exemples qui constituent des modes de réalisation selon l'invention uniquement dans les limites de la revendication 1, le matériau composant le nanofeuillet initial comprend un matériau ME, où
M est Cd,
E est S, Se, ou un mélange de ceux-ci, ou Te.

Dans un mode de réalisation, le matériau semi-conducteur composant le nanofeuillet initial comprend un composant du groupe II-VI.

Dans un mode de réalisation, le matériau composant le nanofeuillet initial comprend au moins un semi-conducteur choisi parmi CdS, CdSe, ou un mélange de ceux-ci, ou CdTe.

Dans un mode de réalisation, le matériau composant le nanofeuillet initial comprend au moins un semi-conducteur choisi préférentiellement parmi CdS, CdSe, CdTe.

Dans un mode de réalisation, le nanofeuillet initial est tel que décrit ci-dessus.

Dans des exemples qui constituent des modes de réalisation selon l'invention uniquement dans les limites de la revendication 3, le précurseur du matériau à déposer est un précurseur d'un matériau qui peut être MxEy, où
M est Zn, Cd, ou un mélange de ceux-ci,
E est O, S, Se, Te, ou un mélange de ceux-ci,
et x et y sont indépendamment un nombre décimal de 0 à 5.

Dans un mode de réalisation, le précurseur du matériau à déposer est un précurseur d'un composant du groupe II-VI

Dans un mode de réalisation dans les limites de la revendication 3, le précurseur du matériau à déposer est un précurseur d'au moins un semi-conducteur choisi parmi CdS, CdSe, CdTe, ZnS, ZnSe, ZnTe, ZnO, ou un mélange de ceux-ci.

Dans un mode de réalisation, le précurseur du matériau à déposer est un précurseur d'au moins un semi-conducteur choisi préférentiellement parmi CdS, CdSe, CdTe, ZnS, ZnSe, ZnTe.

Dans des exemples, qui constituent des modes de réalisation selon l'invention uniquement dans les limites de la revendication 3, le film ou la couche de matériau déposé comprend une composition MxEy comportant des éléments M sous forme cationique et E sous forme anionique en rapport stoechiométrique, le rapport stoechiométrique étant caractérisé par les valeurs x et y correspondantes aux valeurs absolues des degrés d'oxydation moyens des éléments E et M respectivement.

Dans un mode de réalisation, si E est un chalcogène, le précurseur de E est un composé contenant le chalcogène au degré d'oxydation -2.

Dans un mode de réalisation, si E est du soufre, le précurseur de E est un sel contenant des ions sulfure S²⁻ .

Dans un mode de réalisation, le précurseur de E comprend le sulfure de bis(triméthylsilyle) (TMS₂S) ou le sulfure d'hydrogène (H₂S) ou l'hydrogénosulfure de sodium (NaSH) ou le sulfure de sodium (Na₂S), ou le sulfure d'ammonium (S(NH₄)₂) , ou la thiourée, ou la thioacétamide.

Dans un mode de réalisation, si E est du sélénium, le précurseur de E comprend un sel contenant les ions séléniure Se²⁻.

Dans un mode de réalisation, le précurseur de E comprend le séléniure de bis(triméthylsilyle) (TMS₂Se) ou le séléniure d'hydrogène (H₂Se) ou le séléniure de sodium (Na₂Se) ou l'hydrogénoséléniure de sodium (NaSeH) ou le séléniosulfate de sodium (Na₂SeSO₃), ou la sélénourée.

Dans un mode de réalisation, si E comprend du tellure, le précurseur de E est un sel contenant des ions tellurure Te²⁻.

Dans un mode de réalisation, le précurseur de E comprend le tellurure de bis(triméthylsilyle) (TMS₂Te) ou le tellurure d'hydrogène (H₂Te) ou le tellurure de sodium (Na₂Te) ou l'hydrogénotellurure de sodium (NaTeH) ou le tellurosulfate de sodium (Na₂TeSO₃).

Dans un mode de réalisation, si E est un chalcogène, le précurseur de E est formé in-situ par réaction d'un réducteur avec un composé contenant E au degré d'oxydation 0 ou à un degré d'oxydation strictement positif.

Dans un mode de réalisation, si E est de l'oxygène le précurseur de E est l'ion hydroxyde (HO⁻).

Dans un mode de réalisation, si E est de l'oxygène le précurseur de E est une solution de soude (NaOH) ou de potasse (KOH) ou d'hydroxyde de tétraméthylammonium (TMAOH).

Dans un mode de réalisation, si M est un métal, le précurseur de M est un composé contenant le métal dans un degré d'oxydation positif ou nul.

Dans un mode de réalisation, si M est un métal, le précurseur de M comprend un sel métallique.

Dans un mode de réalisation, le sel métallique est un carboxylate de M, ou un chlorure de M, ou un nitrate de M, ou un sulfate de M, ou un thiolate de M.

Dans un mode de réalisation, le film ou la couche de composition MxEy déposé comprend un chalcogènure ou un oxyde.

Dans des exemples qui constituent des modes de réalisation selon l'invention uniquement dans les limites de la revendication 3, le matériau composant la au moins une couche comprend un matériau ME où
M est Zn, Cd, ou un mélange de ceux-ci,
E est O, S, Se, Te ou un mélange de ceux-ci.

Dans un mode de réalisation, le matériau composant la au moins une couche comprend un composant du groupe II-VI.

Dans un mode de réalisation dans les limites de la revendication 3, le matériau composant la au moins une couche comprend au moins un semi-conducteur choisi parmi CdS, CdSe, CdTe, ZnS, ZnSe, ZnTe, ZnO, ou un mélange de ceux-ci.

Dans un mode de réalisation, le matériau composant la au moins une couche comprend au moins un semi-conducteur choisi préférentiellement parmi CdS, CdSe, CdTe, ZnS, ZnSe, ZnTe.

Dans un mode de réalisation, le film ou la couche déposé comprend un alliage des matériaux précédemment cités.

Dans un mode de réalisation, le film ou la couche déposé contient un métal de transition ou un lanthanide en quantité minoritaire (dopage).

Dans un mode de réalisation, le film ou la couche déposé contient en quantités minoritaires un élément produisant un excès ou un déficit d'électrons par rapport au film seul (dopage électronique).

Dans un mode de réalisation, le film ou la couche de matériau déposé comprend un métal.

Dans un mode de réalisation, le métal déposé est choisi parmi l'or, l'argent, le nickel, le molybdène, l'aluminium.

Dans un mode de réalisation, un réducteur peut être introduit en même temps que le ou les précurseurs du film ou de la couche à déposer.

Dans un mode de réalisation, le réducteur comprend un hydrure.

Dans un mode de réalisation, le réducteur comprend du dihydrogène.

Dans un mode de réalisation, l'hydrure comprend le tétrahydruroborate de sodium (NaBH₄), l'hydrure de sodium (NaH), le tétrahydruroaluminate de lithium (LiAlH₄), l'hydrure de diisobutylaluminium (DIbAlH).

Dans un mode de réalisation, le nanofeuillet initial est dispersé dans un solvant de dispersion.

Dans un mode de réalisation, le milieu de dispersion est un milieu organique, de préférence apolaire ou faiblement polaire.

Dans un mode de réalisation, le solvant de dispersion des nanofeuillets est choisi parmi l'eau distillée, le méthanol, l'éthanol, l'isopropanol, le butanol, le chloroforme, l'acétone, l'hexane, le tétrahydrofurane, le diméthylsulfoxyde, le toluène, l'octadécène, et le diméthylformamide.

Dans un mode de réalisation, le solvant de dispersion des nanofeuillets est un fluide supercritique ou un liquide ionique.

Dans un mode de réalisation, un composé de stabilisation apte à stabiliser le ou les particules ou objets finaux en solution peut être introduit dans le solvant de dispersion.

Dans un mode de réalisation, un composé de stabilisation apte à stabiliser le ou les particules ou objets finaux en solution peut être introduit dans l'une quelconque des solutions de précurseurs.

Dans un mode de réalisation, le composé de stabilisation des particules ou objets finaux comprend un ligand organique.

Dans un mode de réalisation, le ligand organique comprend un acide carboxylique, un thiol, une amine, une phosphine, un amide, un ester, une pyridine, un imidazole, un alcool.

Dans un mode de réalisation, le composé de stabilisation du ou des particules ou objets finaux est un ion.

Dans un mode de réalisation, l'ion de stabilisation comprend un ammonium quaternaire.

Dans un mode de réalisation, le débit d'introduction de la ou des solutions de précurseurs est choisi de manière à ce que la vitesse de croissance en épaisseur des nanofeuillets soit comprise entre 1nm par seconde et 0.1nm par heure.

Dans un mode de réalisation, le débit d'introduction de la ou des solutions de précurseurs est choisi de manière à ce que la vitesse de croissance en épaisseur des nanofeuillets soit comprise entre 1nm par seconde et 0,1 nm/jour.

Dans un mode de réalisation, la ou les solutions de précurseurs sont ajoutées en goutte à goutte.

Dans un mode de réalisation, la ou les solutions de précurseurs sont ajoutées en une seule fois directement dans le milieu réactionnel.

Dans un mode de réalisation, la température du milieu réactionnel est de -40°C à 80°C, d'environ 60°C (60°C ± 5°C).

Dans un mode de réalisation, la température du milieu réactionnel est la température ambiante.

Dans un mode de réalisation, le temps t de réaction du précurseur est inférieur à quelques heures.

Dans un mode de réalisation, le temps t de réaction du précurseur est inférieur 24h, ou inférieur à 12h, ou inférieur à 6h, ou inférieur à 4h, ou inférieur à 2h, ou inférieur à 1h.

Dans un mode de réalisation, le temps t de réaction du précurseur est inférieur à quelques jours.

Dans un mode de réalisation, l'excédent de précurseur est éliminé après réaction.

Dans un mode de réalisation, la particule ou l'objet final obtenu après réaction du ou des précurseurs sur les nanofeuillets initiaux est purifié.

Dans un mode de réalisation, la purification est réalisée par floculation et/ou précipitation, ou par filtration.

Dans un mode de réalisation, le nanofeuillet initial peut être fixé sur au moins un substrat.

Dans un mode de réalisation, la fixation du ou des nanofeuillets initial sur ledit au moins un substrat est réalisée par adsorption ou par couplage chimique.

Dans un mode de réalisation, ledit substrat est choisi parmi la silice SiO₂, l'alumine Al₂O₃, l'oxyde d'indium-étain ITO, l'oxyde d'étain dopé au fluor (FTO), l'oxyde de titane TiO₂, l'or, l'argent, le nickel, le molybdène, l'aluminium, le silicium, le germanium, le carbure de silicium SiC, le graphène et la cellulose.

Dans un mode de réalisation, ledit substrat comprend un polymère.

Dans un mode de réalisation, un procédé de recuit est mis en place afin de diminuer la rugosité de surface de la particule ou de l'objet final.

La présente divulgation a également pour objet l'utilisation des particules ou objets finaux tels que décrits ci-dessus.

En effet, ces particules ou objets finaux accrus ultérieurement dans l'épaisseur présentent de nombreuses propriétés et avantages telles que un rendement quantique élevé, une stabilité accrue, une meilleure stabilité de surface, une faible largeur à mi-hauteur de fluorescence (moins de 30nm, de préférence moins de 25nm), un temps de vie de fluorescence rapide (moins de 40 ns, de préférence moins de 10ns), une section efficace d'absorption importante (environ ou plus de 10⁻¹³ cm² à 400nm), un réglage possible de la longueur d'onde d'émission, une robustesse dans le temps des propriétés optiques, une grande surface spécifique.

Ces différentes propriétés font des particules ou objets finaux tels que décrits ci-dessus des objets très utiles pour des applications en fluorescence, notamment dans les systèmes luminescents, électroluminescents ou les étages d'amplification d'un laser.

A titre d'exemple, les nanofeuillets de CdSe recouverts d'une coque de CdS ou de CdZnS tels que décrits dans les exemples présentent un rendement quantique élevé qui peut être de plus de 60% ainsi qu'une largeur à mi-hauteur de l'émission de fluorescence étroite (moins de 20 nm). D'autres exemples de particules ou objets finaux utiles pour des applications en fluorescence sont les nanofeuillets de CdS recouverts de ZnS (CdS/ZnS), les nanofeuillets en CdSeₓS_{1-X} (x étant un nombre décimal variant de 0 à 1) recouverts de Cd_{y}Zn_{1-y}S (y étant un nombre décimal variant de 0 à 1) (CdSeS/CdZnS), les nanofeuillets en CdSeₓS_{1-X} (x étant un nombre décimal variant de 0 à 1) recouverts de ZnS (CdSeS/ZnS), les nanofeuillets en CdTe recouverts de Cd_{y}Zn_{1-y}SeₓS₁₋ₓ ((x et y étant des nombres décimaux variant de 0 à 1 indépendamment) (CdTe/CdZnSeS), les nanofeuillets de CdS recouverts de ZnS dopé au manganèse II ou au cuivre II CdS/ZnS :Mn ou CdS/ZnS :Cu.

Ces particules ou objets finaux tels que décrits ci-dessus sont également très utiles en tant que catalyseurs du fait de leur grande surface spécifique, leur stabilité accrue, leur section efficace d'absorption importante.

A titre d'illustration, les nanofeuillets de CdS, de ZnS, les alliages de ceux-ci et les nanofeuillets de CdSe peuvent par exemple être recouverts de platine et/ou de sulfure de palladium. Le composite obtenu présente une activité photocatalytique de production du dihydrogène. D'autres exemples de particules ou objets finaux utiles pour des applications de catalyse sont les nanofeuillets en CdS ou en CdSe recouverts de TiO₂, les nanofeuillets de CdSe ou CdS recouverts d'une couche métallique telle que Cu, Ag, Au, Ni, Pd, Pt, Co, Fe, Ru, Os, Mn, Tc, Re, Cr, Mo, W, V, Nd, Ta, Ti, Zr, Hf.

Ces particules ou objets finaux tels que décrits ci-dessus sont également très utiles en tant qu'élément absorbeur et/ou collecteur d'une cellule photovoltaïque, du fait de leur stabilité accrue, d'une mobilité électrons/trous augmentée et d'une section efficace d'absorption importante.

A titre d'exemple, des nanofeuillets de CdSe de dimensions importantes (plus de 100 nm de dimensions latérales) peuvent être recouverts d'une coque dopée (CdZnS dopée Ag⁺ par exemple). Ce qui permet d'augmenter la mobilité électronique des éléments absorbeurs et collecteurs d'une cellule solaire contenant de tels objets finaux : CdSe/CdTe, CdTe/CdSe, PbSe/PbS, ZnS/InP, CuInS2/ZnS, CdS/CuInS₂.
Ces particules ou objets finaux tels que décrits ci-dessus sont également très utiles en tant que transistor à effet de champ du fait de leur stabilité accrue, d'une mobilité électrons/trous augmentée et d'une densité de porteurs de charge importante.

A titre d'exemple, des nanofeuillets de CdSe de dimensions importantes (plus de 100 nm de dimensions latérales) peuvent être recouverts d'une coque dopée (CdZnS dopée Ag⁺ par exemple). Ce qui permet d'augmenter la mobilité électronique au sein des objets finaux. De même, un feuillet de semi-conducteur de bande interdite faible recouvert d'une coque de semi-conducteur de bande interdite importante permet d'obtenir une mobilité élevée tout en conservant une structure excitonique. Des nanofeuillet en PbS recouvert d'une couche en CdS est un exemple de particules ou objets finaux utiles pour des applications de transistors à effet de champ.

Un autre aspect de l'invention concerne un système luminescent, un système électroluminescent, un étage d'amplification d'un laser, un catalyseur à grande surface spécifique et cristallinité de surface contrôlée, un élément absorbeur et/ou collecteur d'une cellule photovoltaïque ou un transistor à effet de champ comportant un matériau obtenu du procédé selon un mode de réalisation de l'invention.

D'autres caractéristiques et avantages du procédé selon l'invention apparaitront à la lecture de la description détaillée et des exemples de réalisation donnés ci-après à titre purement illustratif.

### BRÈVE DESCRIPTION DES FIGURES

La figure 1 montre la structure cristalline d'un nanofeuillet de CdSe vu en coupe selon un mode de réalisation de l'invention.
La figure 2 montre la structure schématique d'un nanofeuillet hétéro-structuré vu en coupe selon un mode de réalisation de l'invention.
La figure 3 montre la structure schématique d'un nanofeuillet hétéro-structuré obtenu par croissance après immobilisation sur un substrat vu en coupe selon un mode de réalisation de l'invention.
La figure 4 montre les spectres d'absorbance (en noir), de fluorescence (en rouge) et d'excitation de photoluminescence (en gris) de nanofeuillets coeur/coque dont le feuillet initial est en CdSe et la coque est en Cd_{0,7}Zn_{0,3}S tels qu'obtenus selon un mode de réalisation de l'invention décrit en exemple.
La figure 5 montre une image de microscopie électronique à transmission en utilisant un détecteur annulaire champ sombre grand angle des nanofeuillets coeur/coque vus à plat dont le feuillet initial est en CdSe et la coque est en Cd_{0,7}Zn_{0,3}S tels qu'obtenus selon un mode de réalisation de l'invention décrit en exemple.
La figure 6 montre une image de microscopie électronique à transmission haute résolution en utilisant un détecteur annulaire champ sombre grand angle des nanofeuillets coeur/coque vus sur la tranche dont le feuillet initial est en CdSe (apparaît plus clair) et la coque est en Cd_{0,7}Zn_{0,3}S (apparaît plus sombre) tels qu'obtenus selon un mode de réalisation de l'invention décrit en exemple.

### EXEMPLES

### Feuillets initiaux:

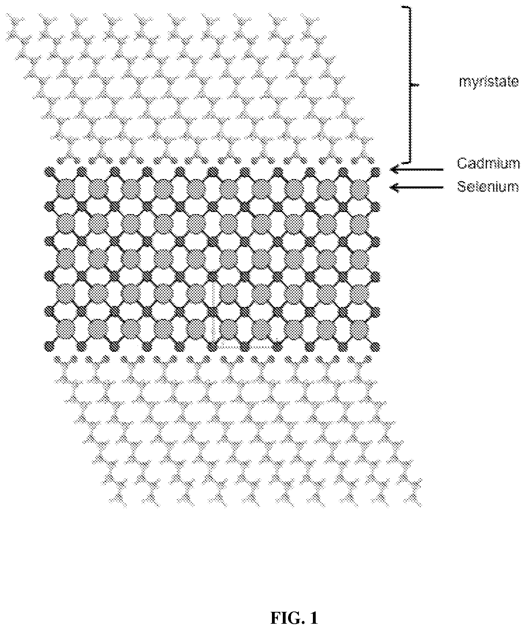

Les feuillets initiaux sur lesquels un procédé de croissance en épaisseur selon au moins un mode de réalisation de l'invention est particulièrement efficace sont les feuillets présentant une charge nette de surface. Cette charge nette de surface peut être positive ou négative suivant la nature du feuillet considéré. Les feuillets de semi conducteur tels que décrits ci-dessus (par exemple CdSe, CdS ou CdTe) font partie de cette classe de matériaux et seront pris comme exemples non limitatifs de feuillets initiaux. Un tel feuillet dont la structure est schématisée sur la figure 1 a une structure zinc-blende, d'axe de zone [0, 0, 1] et présente une surface cationique stabilisée par des carboxylates sur chaque face du feuillet. Ces faces sont parfaitement polaires (dans ce cas, cationiques).

Les feuillets de CdSe par exemple peuvent être obtenus par toute méthode connue à l'homme du métier, tel que décrit par exemple dans les documents suivants : Ithurria, S.; Dubertret, B. Journal of the American Chemical Society 2008, 130, 16504-5 et Ithurria, S.; Bousquet, G.; Dubertret, B. Journal of the American Chemical Society 2011, 133, 3070-7. 174mg de Cd(myristate)₂ et 12mg de Sélénium en poudre sont introduits dans un ballon tricol contenant 16mL d'1-octadecene (ODE, 90%). Le ballon est dégazé sous pression réduite et sous agitation à température ambiante durant 30 minutes. De l'Argon est introduit dans le ballon qui est alors chauffé. Quand la température atteint 200°C, 40mg de Cd(Acétate)₂(H2O)₂ sont rapidement introduits dans le milieu réactionnel induisant la croissance des feuillets. Le milieu réactionnel est porté à 240°C, température à laquelle il est maintenu pendant environ 10 minutes afin d'assurer la croissance des feuillets. La solution est alors refroidie et lavée par précipitations et suspensions successives. La première précipitation est effectuée par ajout d'un non solvant : l'éthanol (80mL environ) et centrifugation (5000 tours par minute pendant 10minutes). Le surnageant est éliminé et le précipité suspendu dans de l'hexane (10mL environ). La solution de feuillets contient encore une grande quantité de Cd(myristate)₂ utilisé en excès. L'ajout de quelques millilitres d'octylamine (4mL) permet sa dissolution. La suspension de plaquettes est alors précipitée une deuxième fois par ajout d'éthanol (80mL) et centrifugation. Le procédé de suspension/ précipitation est répété encore 2 fois avec de l'octylamine puis une dernière fois simplement par suspension dans l'hexane et précipitation à l'éthanol. Le précipité final est suspendu dans 10mL de chloroforme (CHCl₃). Les feuillets obtenus présentent la structure schématisée figure 1, qui montre la structure cristalline d'un feuillet de CdSe vu en coupe.

### Dépôt d'un film de chalcogénure sur les feuillets

On décrit par exemple le dépôt d'un film de CdS sur les feuillets initiaux de CdSe selon un mode de réalisation de l'invention.

Dans un pilulier sont introduits successivement 2mL de chloroforme, 400 µL de la solution de feuillets de CdSe, 20mg de thioacétamide (TAA) ainsi que 200 µL d'octylamine. La solution est placée sous agitation magnétique pendant une heure, ce qui entraine la dissolution complète du TAA puis un changement de couleur de la solution. 200 µL d'une solution de Cd(Oléate)₂ à 0.1M dans une solution 4 :1 d'octylamine et d'acide oléique sont alors rapidement injectés dans la solution de feuillets. Celle-ci change à nouveau graduellement de couleur tandis que le rendement quantique de fluorescence augmente fortement. Les précurseurs sont laissés à réagir sur les feuillets pendant encore deux heures. Les feuillets sont alors agrégés par ajout de quelques gouttes d'éthanol et la solution est centrifugée 5 minutes à 5000 tours/min. Le surnageant contenant les précurseurs n'ayant pas réagit ainsi que des nanocristaux de CdS parasites est supprimé et le culot formé par les feuillets est dispersé dans 2mL de chloroforme auxquels sont ajoutés 20 µL de solution de Cd(Oléate)₂ à 0.5M dans l'acide oléique. Le rendement quantique de fluorescence chute alors fortement. Il raugmente par la suite sous rayonnement ultraviolet.

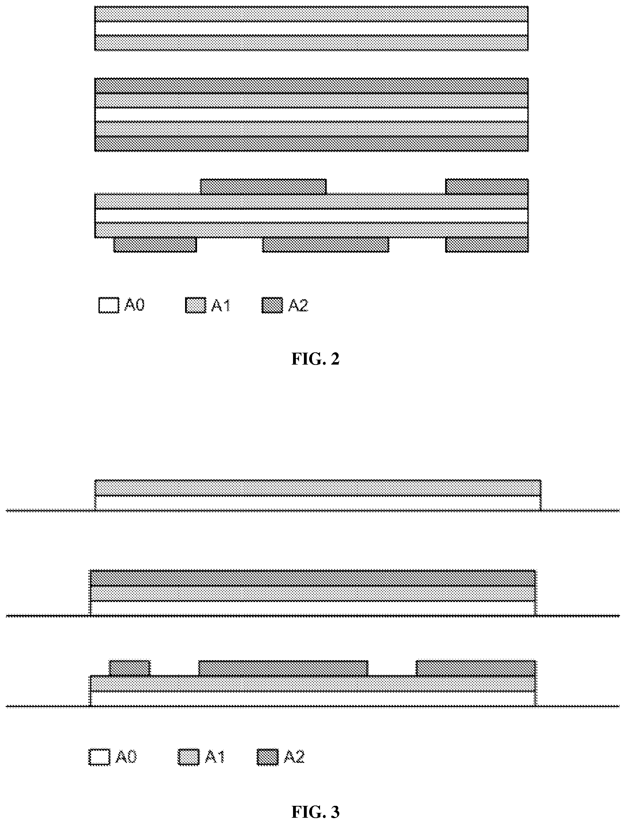

Le procédé selon ce mode de réalisation de l'invention permet de déposer un film de CdS de chaque côté des feuillets de CdSe. L'épaisseur de ce film est contrôlée par le temps de réaction et par la quantité de précurseurs introduite dans le milieu réactionnel. La structure finale des feuillets obtenus est schématisée figure 2, ou A0 est le CdSe, et A1 est le CdS.

### Dépôt d'un film d'oxyde sur les feuillets.

On décrit par exemple le dépôt d'un film d'oxyde de zinc (ZnO) sur des feuillets initiaux de CdSe selon un mode de réalisation de l'invention.

2mL de la solution de feuillets de CdSe dans CHCl₃ sont introduits dans un pilulier et placés sous agitation magnétique. 5mg d'hydroxyde de tétraméthylammonium ainsi que 30mg de Zn(stéarate)₂ sont dissout dans 2mL d'octylamine. Cette solution est alors injectée goutte à goutte pendant deux heures dans la solution de feuillets. La couleur de la solution de feuillets change au cours de l'injection. Après deux heures de réaction, les feuillets sont précipités par ajout d'éthanol et centrifugés. Ils sont alors dispersés dans 2mL de chloroforme.

Le procédé selon ce mode de réalisation de l'invention permet de déposer un film de ZnO de chaque coté des feuillets de CdSe. L'épaisseur de ce film est contrôlée par le temps de réaction et par la quantité de précurseurs introduite dans le milieu réactionnel. La structure finale des feuillets obtenus est schématisée figure 2, ou A0 est le CdSe, et A1 est le ZnO.

### Dépôt d'un film métallique

On décrit par exemple le dépôt d'or sur des feuillets initiaux de CdSe selon un mode de réalisation de l'invention. Ces derniers présentant une charge de surface positive, il est tout d'abord nécessaire d'inverser celle-ci. On effectue cette inversion par dépôt d'une monocouche de soufre en surface des feuillets.

2mL de la solution de feuillets de CdSe dans CHCl₃ ainsi que 100µL de solution de sulfure de tétraméthylammonium (1 M) dans l'éthanol sont introduits dans un pilulier. Sous agitation la couleur de la solution contenant les feuillets change immédiatement et ceux-ci s'agrègent. Après 10 minutes de réaction, les feuillets sont précipités par centrifugation. Le surnageant est supprimé et les feuillets lavés deux fois à l'éthanol. Les feuillets sont suspendus dans de l'eau distillée.

On ajoute alors goutte à goutte dans la solution de feuillets une solution de HAuCl₄ à 0,1M. La couleur de la solution change progressivement du fait du dépôt de l'or en surface des feuillets. Les feuillets finaux sont lavés deux fois par précipitation à l'éthanol. La structure finale des feuillets obtenus selon au moins ce mode de réalisation de l'invention est schématisée figure 2, ou A0 est le CdSe, et A1 est de l'or (Au).

Selon un autre mode de réalisation de l'invention, on décrit par exemple le dépôt d'une couche d'or sur les nanofeuillets initiaux.

Dans un pilulier sont introduits successivement 2mL de chloroforme, 400 µL de la solution de feuillets de CdSe, 20mg de thioacétamide (TAA) ainsi que 200 µL d'octylamine. La solution est soumise à sonication pendant cinq minutes, ce qui entraine la dissolution complète du TAA ainsi qu'un changement de couleur de la solution de jaune à orange. Les feuillets sont alors agrégés par ajout de quelques gouttes d'éthanol el la solution est centrifugée 5 minutes à 5000 tours/min. Le surnageant contenant les précurseurs n'ayant pas réagit est supprimé et le culot formé par les feuillets est dispersé dans 2mL de toluène. On y ajoute alors 2mL d'une solution de précurseurs d'or et de ligands préparée par dissolution dans 10mL de toluène de 10mg d'AuCl₃, 80mg de bromure de didodecyldimethylammonium ainsi que 120mg de dodecylamine. Le mélange est laissé à réagir durant quinze minutes. Les objets coeur/coque résultant sont précipités par centrifugation 5 minutes à 5000 tours/min, les surnageant est supprimé et le culot dispersé dans 2mL de toluène.

### Dépôt d'un film d'un alliage

On décrit par exemple le dépôt d'un alliage de sulfure de cadmium et de sulfure de zinc CdZnS sur des feuillets initiaux de CdSe, selon un mode de réalisation de l'invention.

Dans un pilulier sont introduits successivement 2mL de chloroforme, 400 µL de la solution de feuillets de CdSe, 20mg de thioacétamide (TAA) ainsi que 200 µL d'octylamine. La solution est placée sous agitation magnétique pendant une heure, ce qui entraine la dissolution complète du TAA puis un changement de couleur de la solution. 200 µL d'une solution de Cd(Oléate)₂ à 0.05M et de Zn(Oléate)₂ à 0.05M dans une solution 4 :1 d'octylamine et d'acide oléique sont alors rapidement injectés dans la solution de feuillets. Celle-ci change à nouveau graduellement de couleur tandis que le rendement quantique de fluorescence augmente fortement. Les précurseurs sont laissés à réagir sur les feuillets pendant encore deux heures. Les feuillets sont alors agrégés par ajout de quelques gouttes d'éthanol el la solution est centrifugée 5 minutes à 5000 tours/min. Le surnageant contenant les précurseurs n'ayant pas réagit ainsi que des nanocristaux ce CdZnS parasites est supprimé et le culot formé par les feuillets est dispersé dans 2mL de chloroforme. 20 µL de solution de Zn(Oléate)₂ à 0.5M dans l'acide oléique. Le rendement quantique chute alors fortement. Il raugmente par la suite sous rayonnement ultraviolet.

Le procédé selon ce mode de réalisation de l'invention permet de déposer un film de CdZnS de chaque côté des feuillets de CdSe. L'épaisseur de ce film est contrôlée par le temps de réaction et par la quantité de précurseurs introduite dans le milieu réactionnel. La structure finale des feuillets obtenus est schématisée figure 2, ou A0 est le CdSe, et A1 est le CdZnS.

On décrit par exemple le dépôt d'un alliage de sulfure de cadmium et de sulfure de zinc Cd_{0.7}Zn_{0.3}S sur des feuillets initiaux de CdSe, selon un mode de réalisation de l'invention.

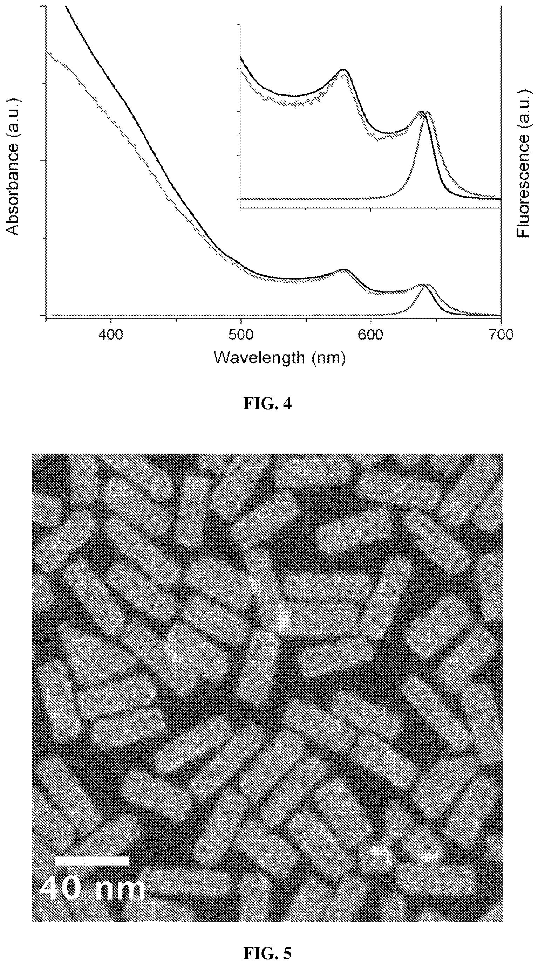

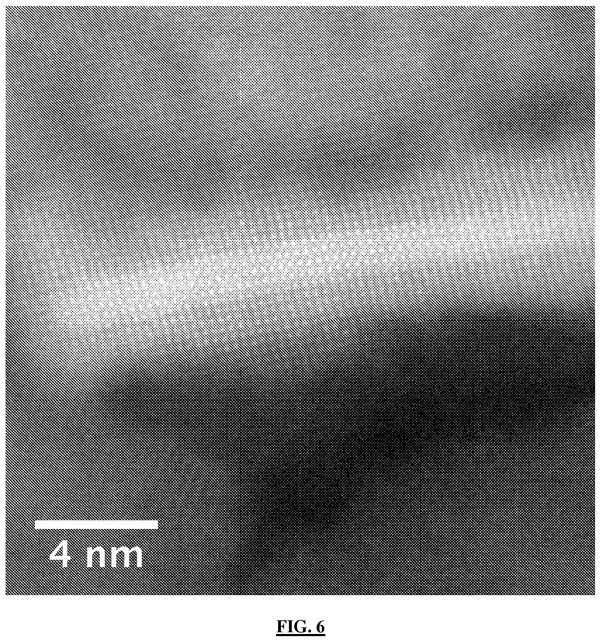

Dans un pilulier sont introduits successivement 4mL de chloroforme, 1 mL de la solution de feuillets de CdSe, 100 mg de thioacétamide (TAA) ainsi que 1mL d'octylamine. La solution est soumise à sonication pendant cinq minutes, ce qui entraine la dissolution complète du TAA ainsi qu'un changement de couleur de la solution de jaune à orange. 350 µL d'une solution de Cd(NO₃)₂ à 0.2M dans l'éthanol et 150 µL d'une solution de Zn(NO₃)₂ à 0.2M dans l'éthanol sont alors rapidement injectés dans la solution de feuillets. Celle-ci change à nouveau graduellement de couleur tandis que le rendement quantique de fluorescence augmente fortement. Les précurseurs sont laissés à réagir sur les feuillets pendant encore 24 heures à température ambiante. Les feuillets sont alors agrégés par ajout de quelques gouttes d'éthanol el la solution est centrifugée 5 minutes à 4000 tours/min. Le surnageant contenant les précurseurs n'ayant pas réagit ainsi que des nanocristaux de CdZnS parasites est supprimé et le culot formé par les feuillets est dispersé dans 5 mL de chloroforme. Afin d'améliorer la stabilisation et le rendement quantique des feuillets, 100 µL d'une solution de Zn(NO₃)₂ à 0.2M dans l'éthanol est ajouté à la solution de plaquettes. Elles s'agrègent immédiatement et sont dispersés par ajout de 200 µL d'acide oléique. Les nanofeuillets coeur/coque obtenus par ce mode de réalisation présentent les spectres d'absorbtion (noir) de fluorescence (rouge) et d'excitation de photoluminescence (gris) présentés figure 4. Leur morphologie est caractérisée en microscopie électronique à transmission en utilisant un détecteur annulaire champ sombre grand angle (HAADF, « high angle annular dark field »). De nombreux nanofeuillets déposés à plat sont visibles sur la figure 5 tandis qu'une image haute résolution (figure 6) permet de distinguer le nanofeuillet initial (brillant au centre) de la coque (plus sombre).

Le procédé selon ce mode de réalisation de l'invention permet de déposer un film de CdZnS de chaque côté des feuillets de CdSe. L'épaisseur de ce film est contrôlée par le temps de réaction et par la quantité de précurseurs introduite dans le milieu réactionnel. La structure finale des feuillets obtenus est schématisée figure 2, ou A0 est le CdSe, et A1 est le CdZnS.

### Dépôt d'un film dopé

On décrit par exemple le dépôt d'un film de sulfure de zinc dopé au manganèse sur des feuillets initiaux de CdS selon un mode de réalisation de l'invention.

Dans un pilulier sont introduits successivement 2mL de chloroforme, 400 µL de la solution de feuillets de CdS, 20mg de thioacétamide (TAA) ainsi que 200 µL d'octylamine. La solution est placée sous agitation magnétique pendant une heure, ce qui entraine la dissolution complète du TAA puis un changement de couleur de la solution. 200 µL d'une solution de Zn(undécanoate)₂ à 0.1M et de Mn(undécanoate)₂ à 0.01M dans l'octylamine sont alors rapidement injectés dans la solution de feuillets. Celle-ci change à nouveau graduellement de couleur tandis que le rendement quantique de fluorescence augmente fortement. Les précurseurs sont laissés à réagir sur les feuillets pendant encore deux heures. Les feuillets sont alors agrégés par ajout de quelques gouttes d'éthanol el la solution est centrifugée 5 minutes à 5000 tours/min. Le surnageant contenant les précurseurs n'ayant pas réagi ainsi que des nanocristaux de ZnS parasites est supprimé et le culot formé par les feuillets est dispersé dans 2mL de chloroforme auxquels sont ajoutés 20 µL de solution de Zn(Oléate)₂ à 0.5M dans l'acide oléique. Le rendement quantique chute alors fortement. Il raugmente par la suite sous rayonnement ultraviolet.

Le procédé selon ce mode de réalisation de l'invention permet de déposer un film de ZnS dopé Manganèse de chaque coté des feuillets de CdS. L'épaisseur de ce film est contrôlée par le temps de réaction et par la quantité de précurseurs introduite dans le milieu réactionnel. La structure finale des feuillets obtenus est schématisée figure 2, ou A0 est le CdS, et A1 est le ZnS dopé manganèse.

### Dépôt successif de plusieurs films de composition chimique différente

On décrit par exemple le dépôt d'un film de sulfure de cadmium puis de sulfure de zinc sur des feuillets initiaux de CdS selon un mode de réalisation de l'invention.

Dans un pilulier sont introduits successivement 2mL de chloroforme, 400 µL de la solution de feuillets de CdSe, 20mg de thioacétamide (TAA) ainsi que 200 µL d'octylamine. La solution est placée sous agitation magnétique pendant une heure, ce qui entraine la dissolution complète du TAA puis un changement de couleur de la solution. 200 µL d'une solution de Cd(Oléate)₂ à 0.1M dans une solution 4 :1 d'octylamine et d'acide oléique sont alors rapidement injectés dans la solution de feuillets. Celle-ci change à nouveau graduellement de couleur tandis que le rendement quantique de fluorescence augmente fortement. Les précurseurs sont laissés à réagir sur les feuillets pendant encore deux heures. Les feuillets sont alors agrégés par ajout de quelques gouttes d'éthanol el la solution est centrifugée 5 minutes à 5000 tours/min. Le surnageant contenant les précurseurs n'ayant pas réagit ainsi que des nanocristaux de CdS parasites est supprimé et le culot formé par les feuillets est dispersé dans 2mL de chloroforme auquels sont ajoutés 20 µL de solution de Cd(Oléate)₂ à 0.5M dans l'acide oléique. Le rendement quantique chute alors fortement. Il raugmente par la suite sous rayonnement ultraviolet. Les feuillets sont alors précipités à l'éthanol et suspendus dans 2mL de chloroforme.

Le procédé selon ce mode de réalisation de l'invention permet de déposer un film de CdS de chaque côté des feuillets de CdSe. L'épaisseur de ce film est contrôlée par le temps de réaction et par la quantité de précurseurs introduite dans le milieu réactionnel.

Pour le dépôt du film de ZnS, 20mg de thioacétamide (TAA) ainsi que 200 µL d'octylamine sont introduits dans le pilulier contenant la solution de feuillets CdSe/CdS dans le chloroforme. La solution est placée sous agitation magnétique pendant une heure, ce qui entraine la dissolution complète du TAA puis un changement de couleur de la solution. 200 µL d'une solution de Zn(undécanoate)₂ à 0.1M dans l'octylamine sont alors rapidement injectés dans la solution de feuillets. Celle-ci change à nouveau graduellement de couleur tandis que le rendement quantique de fluorescence augmente fortement. Les précurseurs sont laissés à réagir sur les feuillets pendant encore deux heures. Les feuillets sont alors agrégés par ajout de quelques gouttes d'éthanol el la solution est centrifugée 5 minutes à 5000 tours/min. Le surnageant contenant les précurseurs n'ayant pas réagi ainsi que des nanocristaux de ZnS parasites est supprimé et le culot formé par les feuillets est dispersé dans 2mL de chloroforme auquels sont ajoutés 20 µL de solution de Zn(Oléate)₂ à 0.5M dans l'acide oléique.

Le procédé selon ce mode de réalisation de l'invention a permis de déposer un film de ZnS de chaque côté des feuillets de CdSe/CdS. L'épaisseur de ce film est contrôlée par le temps de réaction et par la quantité de précurseurs introduite dans le milieu réactionnel.

Le procédé selon ce mode de réalisation de l'invention a ainsi permis de synthétiser des feuillets de structure CdSe/CdS/ZnS en déposant un film de sulfure de cadmium puis d'un film de sulfure de zinc sur des feuillets initiaux de CdSe. La structure finale des feuillets obtenus est schématisée figure 2, ou A0 est le CdSe, A1 est le CdS et A2 est le ZnS.

### Immobilisation de feuillets sur substrat puis croissance :

Une lame de verre de microscope (26mm par 26mm) est nettoyée à l'aide d'un plasma d'oxygène. Elle est ensuite fonctionnalisée au 3-mercaptopropyl-triethoxysilane par immersion pendant 10 minutes dans une solution à 1% en volume de 3-mercaptopropyl-triethoxysilane dans l'éthanol. La lame de verre est rincée 3 fois à l'éthanol puis séchée. Elle est alors immergée durant 1 heure dans une solution de feuillets de CdSe dispersés dans du chloroforme. Les feuillets s'adsorbent à la surface de la lame de verre pour former une monocouche de feuillets. La lame est rincée 2 fois au chloroforme afin de supprimer les feuillets non liés au substrat.

La lame est immergée dans quelques millilitres d'éthanol dans lesquels ont été dissous 20mg de thioacétamide (TAA). Après une heure de réaction, 1mL d'une solution de Cd(Acétate)₂(H₂O)₂ à 0.1M dans l'éthanol est lentement injectée en goutte à goutte durant une heure puis laissée à réagir durant une heure supplémentaire. Après deux rinçages à l'éthanol, la lame de verre est ainsi recouverte d'une couche de feuillets CdSe/CdS. La structure finale des feuillets obtenus est schématisée figure 3, ou A0 est le CdSe, et A1 est le CdS.

Comme il va de soi et comme il résulte d'ailleurs déjà de ce qui précède, l'invention ne se limite nullement à ceux des modes d'applications et de réalisations qui ont été plus spécialement envisagés ; elle en embrasse au contraire toutes les variantes sans pour autant sortir du cadre de l'invention tel que défini par les revendications.

### Bibliographie :

(1) Ekimov, A. JETP Lett 1981, 34, 345-348.
(2) Alivisatos, A. P. Science 1996, 271, 933-937.
(3) Vassiliou, J.; Mehrotra, V.; Russell, M. J. Appl. Phys 1993, 5109-5116.
(4) El-Sayed, M. a Accounts of chemical research 2004, 37, 326-33.
(5) Ma, R.; Sasaki, T. Advanced materials 2010, 22, 5082-104.
(6) Sasaki, T.; Watanabe, M. The Journal of Physical Chemistry B 1997, 101, 10159-10161.
(7) Hernandez, Y.; Nicolosi, V.; Lotya, M.; Blighe, F. M.; Sun, Z.; De, S.; McGovern, I. T.; Holland, B.; Byrne, M.; Gun'Ko, Y. K.; Boland, J. J.; Niraj, P.; Duesberg, G.; Krishnamurthy, S.; Goodhue, R.; Hutchison, J.; Scardaci, V.; Ferrari, A. C.; Coleman, J. N. Nature nanotechnology 2008, 3, 563-8.
(8) Vaughn, D. D.; Patel, R. J.; Hickner, M. a; Schaak, R. E. Journal of the American Chemical Society 2010, 132, 15170-2.
(9) Mehta, R. J.; Karthik, C.; Singh, B.; Teki, R.; Borca-Tasciuc, T.; Ramanath, G. ACS nano 2010, 4, 5055-60.
(10) Kumar, S.; Nann, T. Small 2006, 2, 316-29.
(11) Jun, Y.-wook; Choi, J.-sil; Cheon, J. Angewandte Chemie (International ed. in English) 2006, 45, 3414-39.
(12) Xu, S.; Sun, X.; Ye, H.; You, T.; Song, X.; Sun, S. Materials Chemistry and Physics 2010, 120, 1-5.
(13) Li, C. C.; Cai, W. P.; Cao, B. Q.; Sun, F. Q.; Li, Y.; Kan, C. X.; Zhang, L. D. Advanced Functional Materials 2006, 16, 83-90.
(14) Sigman, M. B.; Ghezelbash, A.; Hanrath, T.; Saunders, A. E.; Lee, F.; Korgel, B. a Journal of the American Chemical Society 2003, 125, 16050-7.
(15) Deng, Z.; Mansuripur, M.; Muscat, A. J. Journal ofMaterials Chemistry 2009, 19, 6201.
(16) Puntes, V. F.; Zanchet, D.; Erdonmez, C. K.; Alivisatos, a P. Journal of the American Chemical Society 2002, 124, 12874-80.
(17) Si, R.; Zhang, Y.-W.; You, L.-P.; Yan, C.-H. Angewandte Chemie (International ed. in English) 2005, 44, 3256-60.
(18) Zhang, G.; Sun, S.; Li, R.; Zhang, Y.; Cai, M.; Sun, X. Chemistry of Materials 2010, 22, 4721-4727.
(19) Sun, Y.; Xia, Y. Science 2002, 298, 2176-9.
(20) Ah, C. S.; Yun, Y. J.; Park, H. J.; Kim, W.-J.; Ha, D. H.; Yun, W. S. Chemistry of Materials 2005, 17, 5558-5561.
(21) Huang, W. L.; Chen, C.-hua; Huang, M. H. The Journal of Physical Chemistry C 2007, 111, 2533-2538.
(22) Deng, Z.; Mansuipur, M.; Muscat, A. J. The Journal of Physical Chemistry C 2009, 113, 867-873.
(23) Yu, T.; Joo, J.; Park, Y. I.; Hyeon, T. Journal of the American Chemical Society 2006, 128, 1786-7.
(24) Xu, R.; Xie, T.; Zhao, Y.; Li, Y. Crystal Growth & Design 2007, 7, 1904-1911.
(25) Yu, J. C.; Xu, A.; Zhang, L.; Song, R.; Wu, L. The Journal of Physical Chemistry B 2004, 108, 64-70.
(26) Joo, J.; Son, J. S.; Kwon, S. G.; Yu, J. H.; Hyeon, T. Journal of the American Chemical Society 2006, 128, 5632-3.
(27) Yu, J. H.; Liu, X.; Kweon, K. E.; Joo, J.; Park, J.; Ko, K.-T.; Lee, D. W.; Shen, S.; Tivakornsasithorn, K.; Son, J. S.; Park, J.-H.; Kim, Y.-W.; Hwang, G. S.; Dobrowolska, M.; Furdyna, J. K.; Hyeon, T. Nature materials 2010, 9, 47-53.
(28) Yu, S. H.; Yoshimura, M. Advanced Materials 2002, 14, 296-300.
(29) Li, J.; Xu, Y.; Wu, D.; Sun, Y. Solid State Communications 2004, 130, 619-622.
(30) Yao, W.-T.; Yu, S.-H.; Pan, L.; Li, J.; Wu, Q.-S.; Zhang, L.; Jiang, J. Small 2005, 1, 320-5.
(31) Fan, L.; Song, H.; Zhao, H.; Pan, G.; Yu, H.; Bai, X.; Li, S.; Lei, Y.; Dai, Q.; Qin, R.; Wang, T.; Dong, B.; Zheng, Z.; Ren, X. The journal of physical chemistry. B 2006, 110, 12948-53.
(32) Park, K. H.; Jang, K.; Son, S. U. Angewandte Chemie (International ed. in English) 2006, 45, 4608-12.
(33) Han-Mei, H.; Chong-Hai, D.; Xian-Huai, H.; Yan, L.; Mei, S.; Ke-Hua, Z. CHINESE JOURNAL OF INORGANIC CHEMISTRY 2007, 23, 1403-1408.
(34) Huang, X.; Li, J. Journal of the American Chemical Society 2007, 129, 3157-62.
(35) Huang, X.; Li, J.; Zhang, Y.; Mascarenhas, A. Journal of the American Chemical Society 2003, 125, 7049-55.
(36) Son, J. S.; Wen, X.-D.; Joo, J.; Chae, J.; Baek, S.-L; Park, K.; Kim, J. H.; An, K.; Yu, J. H.; Kwon, S. G.; Choi, S.-H.; Wang, Z.; Kim, Y.-W.; Kuk, Y.; Hoffmann, R.; Hyeon, T. Angewandte Chemie (International ed. in English) 2009, 48, 6861-4.
(37) Ithurria, S.; Dubertret, B. Journal of the American Chemical Society 2008, 130, 16504-5.
(38) Ithurria, S.; Bousquet, G.; Dubertret, B. Journal of the American Chemical Society 2011, 133, 3070-7.
(39) Li, Z.; Peng, X. Journal of the American Chemical Society 2011, 133, 6578-86.
(40) Hines, M. a; Guyot-Sionnest, P. The Journal of Physical Chemistry 1996, 100, 468-471.
(41) Peng, X. Chemistry 2002, 8, 334-9.
(42) Trindade, T.; O'Brien, P.; Zhang, X.-mei Chemistry of Materials 1997, 9, 523-530.
(43) Mane, R. Materials Chemistry and Physics 2000, 65, 1-31.
(44) Nicolau, Y. Applications of Surface Science 1985, 22, 1061-1074.

## Revendications

1. Une particule colloïdale inorganique comprenant un nanofeuillet inorganique initial recouvert partiellement ou totalement par au moins une couche de matériau inorganique, dans laquelle le nanofeuillet initial et la au moins une couche recouvrant partiellement ou totalement le nanofeuillet initial sont composés d'au moins deux matériaux différents, et dans laquelle la particule colloïdale est choisie parmi CdSe/CdS, CdSe/CdTe, CdSe/Cd_{y}Zn_{1-y}S, CdS/ZnS, CdSeₓS₁₋ₓ/Cd_{y}Zn_{1-y}S, CdTe/Cd_{y}Zn_{1-y}SeₓS₁₋ₓ, CdTe/CdSe, ou CdSe/ZnO, x et y étant des nombres décimaux variant de 0 à 1 indépendamment, **caractérisée en ce que** les dimensions latérales du nanofeuillet initial représentent au moins 3 fois l'épaisseur du nanofeuillet initial.

2. Une particule selon la revendication **1,** ayant une épaisseur de 0,5 nm à 10 mm.

3. Un procédé de croissance en épaisseur d'au moins une face d'au moins un nanofeuillet colloïdal initial par dépôt d'au moins une couche sur tout ou partie du nanofeuillet colloïdal initial conduisant à une particule colloïdale inorganique, le procédé comprenant la mise en contact d'au moins un nanofeuillet colloïdal initial avec au moins une solution de précurseur du matériau de la au moins une couche, dans lequel le nanofeuillet colloïdal initial et la au moins une couche sont composés d'au moins deux matériaux différents, et dans lequel le matériau composant le nanofeuillet colloïdal initial et le matériau composant la au moins une couche sont choisis parmi CdSe/CdS, CdSe/CdTe, CdSe/Cd_{y}Zn_{1-y}S, CdS/ZnS, CdSeₓS₁₋ₓ/Cd_{y}Zn_{1-y}S, CdTe/Cd_{y}Zn_{1-y}SeₓS₁₋ₓ, CdTe/CdSe, ou CdSe/ZnO, x et y étant des nombres décimaux variant de 0 à 1 indépendamment, **caractérisé en ce que** les dimensions latérales du nanofeuillet initial représentent au moins 3 fois l'épaisseur du nanofeuillet initial, et **en ce que** la température du milieu réactionnel est de 40 à 80°C ou la température du milieu réactionnel est la température ambiante.

4. Un procédé selon la revendication **3,** dans lequel le nanofeuillet colloïdal initial est dispersé dans un milieu organique.

5. Un procédé selon la revendication **3** à **4,** dans lequel un composé de stabilisation est en outre ajouté lors de la mise en contact du nanofeuillet colloïdal initial avec la solution de précurseur du matériau à déposer.

6. Un procédé selon l'une quelconque des revendications **3** à **5,** dans lequel les particules obtenues après réaction sont purifiées.

7. Un procédé selon l'une quelconque des revendications **3** à **6,** dans lequel le au moins un nanofeuillet colloïdal initial est fixé sur un substrat.

8. Système luminescent, électroluminescent ou étage d'amplification d'un laser comprenant au moins une particule selon l'une quelconque des revendications 1 ou **2,** et dans lequel la particule colloïdale est choisie parmi CdSe/CdS, CdSe/Cd_{y}Zn_{1-y}S, CdS/ZnS, CdSeₓS₁₋ₓ/Cd_{y}Zn_{1-y}S, ou CdTe/Cd_{y}Zn_{1-y}SeₓS₁₋ₓ, x et y étant des nombres décimaux variant de 0 à 1 indépendamment.

9. Cellule photovoltaïque comprenant au moins une particule selon l'une quelconque des revendications **1** ou **2,** dans laquelle la particule colloïdale est choisie parmi CdSe/CdZnS, CdSe/CdTe, ou CdTe/CdSe, et dans laquelle la au moins une couche de matériau inorganique est dopée.

10. Transistor comprenant au moins une particule selon l'une quelconque des revendications **1** ou **2,** dans lequel la particule colloïdale est CdSe/CdZnS, et dans lequel la au moins une couche de matériau inorganique est dopée.

## Patentansprüche

1. Anorganisches kolloidales Partikel, das ein initiales anorganisches Nanosheet umfasst, das teilweise oder vollständig von mindestens einer Schicht aus anorganischem Material bedeckt ist, wobei das initiale Nanosheet und die mindestens eine Schicht, die das initiale Nanosheet teilweise oder vollständig bedeckt, aus mindestens zwei verschiedenen Materialien bestehen, und wobei das kolloidale Partikel ausgewählt ist aus CdSe/CdS, CdSe/CdTe, CdSe/Cd_{y}Zn_{1-y}S, CdS/ZnS, CdSeₓS₁₋ₓ/Cd_{y}Zn_{1-y}S, CdTe/Cd_{y}Zn_{1-y}SeₓS₁₋ₓ, CdTe/CdSe oder CdSe/ZnO, wobei x und y Dezimalzahlen sind, die unabhängig voneinander von 0 bis 1 variieren, **dadurch gekennzeichnet, dass** die seitlichen Abmessungen des initialen Nanosheets mindestens das 3-fache der Dicke des initialen Nanosheets betragen.

2. Partikel nach Anspruch 1, mit einer Dicke von 0,5 nm bis 10 mm.

3. Verfahren zum Dickenwachstum mindestens einer Seite mindestens eines initialen kolloidalen Nanosheets durch Abscheidung mindestens einer Schicht auf dem gesamten oder einem Teil des initialen kolloidalen Nanosheets, was zu einem anorganischen kolloidalen Partikel führt, wobei das Verfahren das Inkontaktbringen mindestens eines initialen kolloidalen Nanosheets mit mindestens einer Präkursorlösung des Materials der mindestens einen Schicht umfasst, wobei das initiale kolloidale Nanosheet und die mindestens eine Schicht aus mindestens zwei verschiedenen Materialien bestehen, und wobei das Material, aus dem das initiale kolloidale Nanosheet besteht, und das Material, aus dem die mindestens eine Schicht besteht, ausgewählt werden aus CdSe/CdS, CdSe/CdTe, CdSe/Cd_{y}Zn_{1-y}S, CdS/ZnS, CdSeₓS₁₋ₓ/Cd_{y}Zn_{1-y}S, CdTe/Cd_{y}Zn_{1-y}SeₓS₁₋ₓ, CdTe/CdSe oder CdSe/ZnO, wobei x und y Dezimalzahlen sind, die unabhängig voneinander von 0 bis 1 variieren, **dadurch gekennzeichnet, dass** die seitlichen Abmessungen des initiales Nanosheet mindestens das 3-fache der Dicke des initialen Nanosheets betragen, und dass die Temperatur des Reaktionsmediums 40 bis 80 °C beträgt oder die Temperatur des Reaktionsmediums die Umgebungstemperatur ist.

4. Verfahren nach Anspruch 3, wobei das initiale kolloidale Nanosheet in einem organischen Medium dispergiert ist.

5. Verfahren nach Anspruch 3 bis 4, wobei eine Stabilisierungsverbindung ferner zugegeben wird während dem Inkontaktbringen des initialen kolloidalen Nanosheets mit der Präkursorlösung des abzuscheidenden Materials.

6. Verfahren nach einem der Ansprüche 3 bis 5, wobei die Partikel, die nach der Reaktion erhalten wurden, gereinigt werden.

7. Verfahren nach einem der Ansprüche 3 bis 6, wobei das mindestens eine initiale kolloidale Nanosheet auf einem Substrat befestigt ist.

8. Lumineszenz-, Elektrolumineszenz-System oder Verstärkungsstufe eines Lasers, mindestens ein Partikel nach einem der Ansprüche 1 oder 2 umfassend, und wobei das kolloidale Partikel ausgewählt ist aus CdSe/CdS, CdSe/Cd_{y}Zn_{1-y}S, CdS/ZnS, CdSeₓS₁₋ₓ/Cd_{y}Zn_{1-y}S oder CdTe/Cd_{y}Zn_{1-y}SeₓS₁₋ₓ, wobei x und y Dezimalzahlen sind, die unabhängig voneinander von 0 bis 1 variieren.

9. Photovoltaikzelle, mindestens ein Partikel nach einem der Ansprüche 1 oder 2 umfassend, wobei das kolloidale Partikel aus CdSe/CdZnS, CdSe/CdTe oder CdTe/CdSe ausgewählt ist und wobei die mindestens eine Schicht aus anorganischem Material dotiert ist.

10. Transistor, mindestens ein Partikel nach einem der Ansprüche 1 oder 2 umfassend, wobei das kolloidale Partikel CdSe/CdZnS ist und wobei die mindestens eine Schicht aus anorganischem Material dotiert ist.

## Claims

1. An inorganic colloidal particle comprising an initial inorganic nanosheet partially or totally covered by at least one layer of inorganic material, wherein the initial nanosheet and the at least one layer partially or totally covering the initial nanosheet are made of at least two different materials, and wherein the colloidal particle is selected from CdSe/CdS, CdSe/CdTe, CdSe/Cd_{y}Zn_{1-y}S, CdS/ZnS, CdSeₓS₁₋ₓ/Cd_{y}Zn_{1-y}S, CdTe/Cd_{y}Zn_{1-y}SeₓS₁₋ₓ, CdTe/CdSe, or CdSe/ZnO, x and y being decimal numbers ranging from 0 to 1 independently, **characterized in that** the lateral dimensions of the initial nanosheet represent at least 3 times the thickness of the initial nanosheet.

2. A particle according to claim **1,** having a thickness of 0.5 nm to 10 mm.

3. A process for the thickness growth of at least one face of at least one initial colloidal nanosheet by depositing at least one layer on all or part of the initial colloidal nanosheet resulting in an inorganic colloidal particle, the process comprising bringing at least one initial colloidal nanosheet with at least one precursor solution of the material of the at least one layer, wherein the initial colloidal nanosheet and the at least one layer are made of at least two different materials, and wherein the material making up the initial colloidal nanosheet and the material making up the at least one layer are selected from CdSe/CdS, CdSe/CdTe, CdSe/Cd_{y}Zn_{1-y}S, CdS/ZnS, CdSeₓS₁₋ₓ/Cd_{y}Zn_{1-y}S, CdTe/Cd_{y}Zn_{1-y}SeₓS₁₋ₓ, CdTe/CdSe, or CdSe/ZnO, x and y being decimal numbers ranging from 0 to 1 independently, **characterized in that** the lateral dimensions of the initial nanosheet represent at least 3 times the thickness of the initial nanosheet, and **in that** the temperature of the reaction medium is from 40°C to 80°C or the temperature of the reaction medium is the ambient temperature.

4. A process to claim **3,** wherein the initial colloidal nanosheet is dispersed in an organic environment.

5. A process according to claim **3** to **4,** in which a stabilization compound is additionally added when the initial nanosheet is brought into contact with the precursor solution of the material to be deposited.

6. A process according to any one of claims **3** to **5,** wherein the particles obtained after reaction are purified.

7. A process according to any one of claims **3** to **6,** wherein the at least one initial colloidal nanosheet is attached to a substrate.

8. Luminescent systems, electroluminescent systems or laser amplification stages comprising at least one particle according to any one of claims **1** or **2,** and wherein the colloidal particle is selected from CdSe/CdS, CdSe/Cd_{y}Zn_{1-y}S, CdS/ZnS, CdSeₓS₁₋ₓ/Cd_{y}Zn_{1-y}S, or CdTe/Cd_{y}Zn_{1-y}SeₓS₁₋ₓ, x and y being decimal numbers ranging from 0 to 1 independently.

9. A photovoltaic cell comprising at least one particle according to any one of claims **1** or **2,** wherein the colloidal part is selected from CdSe/CdS, CdSe/CdTe, or CdTe/CdSe, and wherein the at least one layer of inorganic material is doped.

10. Transistors comprising at least one particle according to any one of claims **1** or **2,** wherein the colloidal particle is CdSe/CdZnS, and wherein the at least one layer of inorganic material is doped.
